# EUROPEAN PATENT APPLICATION

(11) **EP 1 635 350 A1**
(43) Date of publication of application: **15.03.2006**
(21) Application number: 05019656.7
(22) Date of filing: 09.09.2005
(51) Int. Cl.: G11B 20/12, G11B 20/10

(54) **Information processing apparatus, information processing method, and program**

(30) Priority: 10.09.2004 JP 2004263255
(71) Applicant: SONY CORPORATION, Tokyo (JP)
(72) Inventor: Aida, Kiyoshi, Shinagawa-ku Tokyo (JP); Shimoyoshi, Osamu, Shinagawa-ku Tokyo (JP); Ono, Hideyuki, Shinagawa-ku Tokyo (JP); Utsumi, Yoshinori, Shinagawa-ku Tokyo (JP); Ohkouchi, Toshio, Shinagawa-ku Tokyo (JP); Usukara, Rie, Shinagawa-ku Tokyo (JP)
(74) Representative: Körber, Martin Hans

(57) **Abstract**

An information processing apparatus (1) is disclosed which stores externally captured direct stream digital data (12) into a file (11) for management purposes. The apparatus includes: a file generating section (52) generating the file (11) in such a manner as to hold the direct stream digital data (12) read and written in increments of a data volume higher than one sample of data (S11) according to a direct stream digital method, the file (11) being further arranged to have a storage area (13) for accommodating audio data encoded by an encoding method different from the direct stream digital method (14); and an audio data generating section (58) generating the audio data encoded by the encoding method different from the direct stream digital method in accordance with the direct stream digital data (S4), the audio data generating section further storing the generated audio data into the storage area of the file generated by the file generating section (S5).

## Description

### CROSS REFERENCES TO RELATED APPLICATIONS

The present invention contains subject matter related to Japanese Patent Application JP 2004-263255 filed with the Japanese Patent Office on September 10, 2004, the entire contents of which being incorporated herein by reference.

### BACKGROUND OF THE INVENTION

The present invention relates to an information processing apparatus, an information processing method, and a program. More particularly, the invention relates to an information processing apparatus, an information processing method, and a program for efficiently handling DSD (direct stream digital) data.

Recent years have witnessed a growing popularity of so-called DTM (desktop music). This is a pursuit involving people using their personal computers to capture audio signals from analog sources such as records and cassette tapes or digital audio data from CDs (compact disks) and DATs (digital audio tapes), so that the captured data may be turned into preferred kinds of audio data through editing processes such as the addition of effects and arrangements.

With DTM, demand is growing for higher sound quality. For example, it is now common practice to sample, at a sampling frequency of 96 kHz or higher, music CD audio data (i.e., audio data encoded by PCM (pulse code modulation)) originally sampled at 44.1 kHz in increments of 16 bits. Another common practice involves submitting CD audio data to re-quantization in increments of 20 or 24 bits. These measures are adopted primarily to obtain audio data of higher sound quality than that of music CDs.

There exists SACD (Super Audio CD), another format in which to record audio data at a still higher level of sound quality than music CD audio data. Audio data recorded in SACD format is encoded by the DSD method.

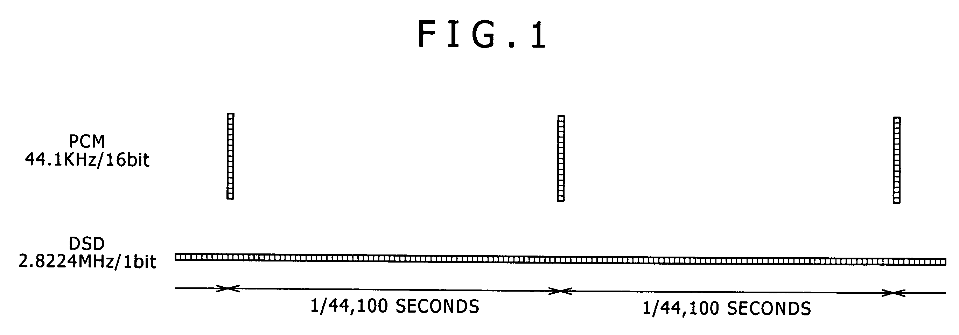

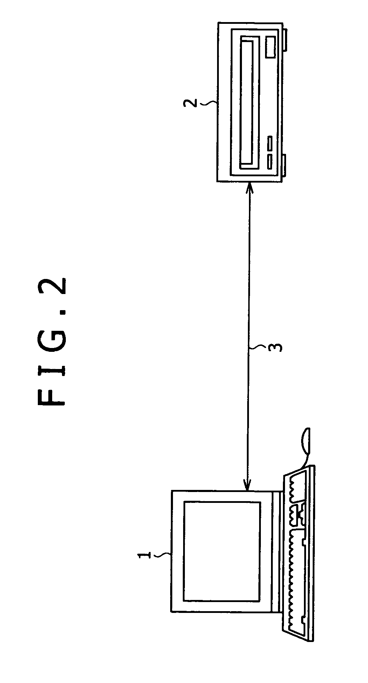

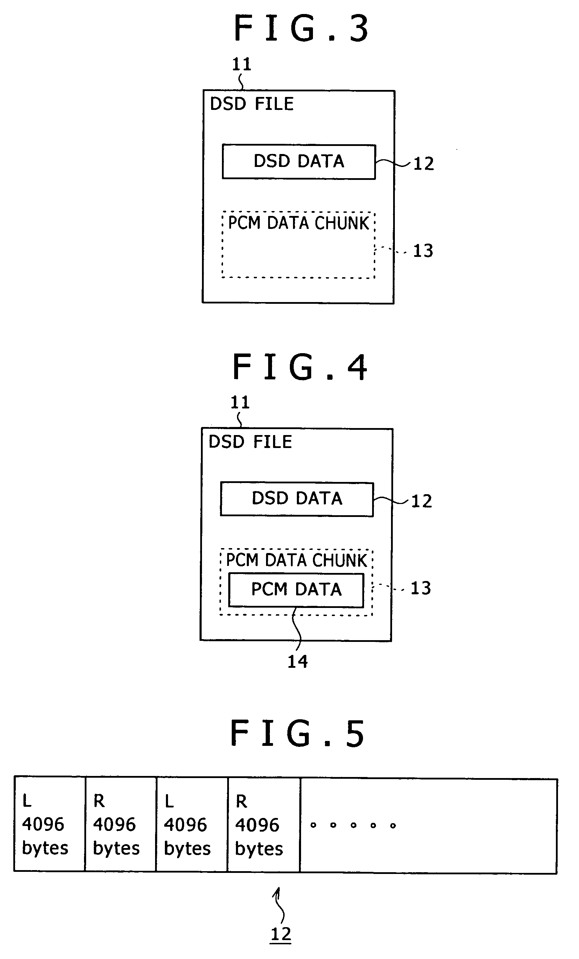

What follows is a brief explanation of the DSD method. The PCM method, as shown in FIG. 1, involves representing audio signals at a sampling frequency of 44.1 kHz (referred to as 1 fs below where appropriate) in increments of quantized 16 bits. By contrast, the DSD method involves expressing audio signals at 64 times the sampling frequency of 44.1 kHz (44.1 kHz × 64 = 2.8224 MHz (64 fs)) in increments of 1 bit. Each block in FIG. 1 denotes one-bit data.

According to the DSD method, the ups and downs of audio signal levels can be expressed in pulse waveforms (1s and 0s). That is, the DSD method permits shaping of waveforms close to sound waves that propagate through the air. The scheme provides a dynamic range of higher than 100 kHz for audio reproduction.

Japanese Patent Laid-open No. Hei 6-232755 discloses aspects of DSD. Japanese Patent Laid-open No. Hei 9-261071 discloses techniques for converting multi-bit (16-bit) audio data ripped from CDs into DSD data (i.e., audio data encoded by the DSD method). Japanese Patent Laid-open No. Hei 8-274644 discloses techniques for applying amplitude-related effects such as fade-in/fade-out to DSD data.

### SUMMARY OF THE INVENTION

As outlined above, there is demand among users of DTM for handling audio data of still higher quality, including DSD data. Conceivably, DSD data may be captured from an external device into the personal computer and the captured data may be managed as a single DSD file for reproduction and editing. However, if DSD data, which occurs only one bit data per sample, were read and written (i.e., interleaved) in increments of one sample, that would constitute a very inefficient process.

In the personal computer, PCM data is generally read and written in increments of 16 bits making up single-sample data. If this kind of data were to be handled in increments of one bit constituting data per sample, the number of times the data is to be read and written would be inordinately higher than the number of times PCM data is read and written.

DSD data composing a given tune is greater in volume than PCM data making up the same tune. Obviously, editing DSD data forming a given set of music data involves larger quantities of data to be read and written than the PCM data forming the same set of music data. Handling one-bit per-sample data can thus be a very inefficient exercise. When DSD data is to be reproduced, it is practically impossible to read the data fast enough to keep up with the playback.

In view of what has been described above, when DSD data is to be handled as one file in the personal computer, that file should preferably be written in a format allowing the DSD data to be written and read more efficiently than has been the case.

At present, not many personal computers are equipped with a DSD device capable of reproducing DSD data. If the user of a personal computer acquires a DSD file prepared by another PC, the user is unable to check what tune is composed of the DSD data in the file unless a DSD device is connected to the user's PC.

The present invention has been made in view of the above circumstances and provides arrangements for efficiently handling DSD data, especially the measures for allowing the user of a PC with no DSD device to ascertain what kind of music is constituted by the DSD data in a DSD file.

According to one embodiment of the present invention, there is provided an information processing apparatus for storing externally captured direct stream digital (DSD) data into a file for management purposes, the information processing apparatus including: a file generating section generating the file in such a manner as to hold the direct stream digital data read and written in increments of a data volume higher than one sample of data according to a direct stream digital (DSD) method, the file being further arranged to have a storage area for accommodating audio data encoded by an encoding method different from the direct stream digital method; and an audio data generating section generating the audio data encoded by the encoding method different from the direct stream digital method in accordance with the direct stream digital data, the audio data generating section further storing the generated audio data into the storage area of the file generated by the file generating section.

Preferably, the audio data may be pulse code modulation (PCM) data for the above-outlined embodiment of the invention.

According to another embodiment of the present invention, there is provided an information processing method for storing externally captured direct stream digital (DSD) data into a file for management purposes, the information processing method including the steps of: generating the file in such a manner as to hold the direct stream digital data read and written in increments of a data volume higher than one sample of data according to a direct stream digital (DSD) method, the file being further arranged to have a storage area for accommodating audio data encoded by an encoding method different from the direct stream digital method; and generating the audio data encoded by the encoding method different from the direct stream digital method in accordance with the direct stream digital data, the audio data generating step further storing the generated audio data into the storage area of the file generated in the file generating step.

According to a further embodiment of the present invention, there is provided a program for causing a computer to store externally captured direct stream digital (DSD) data into a file for management purposes, the program causing the computer to carry out a process including the steps of: generating the file in such a manner as to hold the direct stream digital data read and written in increments of a data volume higher than one sample of data according to a direct stream digital (DSD) method, the file being further arranged to have a storage area for accommodating audio data encoded by an encoding method different from the direct stream digital method; and generating the audio data encoded by the encoding method different from the direct stream digital method in accordance with the direct stream digital data, the audio data generating step further storing the generated audio data into the storage area of the file generated in the file generating step.

According to an even further embodiment of the present invention, there is provided an information processing apparatus for reproducing either direct stream digital (DSD) data or audio data from a file accommodating the two types of data, the direct stream digital data being read and written by a direct stream digital (DSD) method in increments of a data volume higher than one sample of data according to the direct stream digital method, the audio data being encoded by an encoding method different from the direct stream digital method, the information processing apparatus including: a first reproducing section reproducing the direct stream digital data from the file if there is provided a controllable device capable of reproducing the direct stream digital data; and a second reproducing section reproducing the audio data from the file if there is no controllable device capable of reproducing the direct stream digital data.

Preferably, the audio data may be pulse code modulation (PCM) data for the foregoing embodiment of the invention.

According to a still further embodiment of the present invention, there is provided an information processing method for reproducing either direct stream digital (DSD) data or audio data from a file accommodating the two types of data, the direct stream digital data being read and written by a direct stream digital (DSD) method in increments of a data volume higher than one sample of data according to the direct stream digital method, the audio data being encoded by an encoding method different from the direct stream digital method, the information processing method including the steps of: firstly reproducing the direct stream digital data from the file if there is provided a controllable device capable of reproducing the direct stream digital data; and secondly reproducing the audio data from the file if there is no controllable device capable of reproducing the direct stream digital data.

According to a yet further embodiment of the present invention, there is provided a program for causing a computer to reproduce either direct stream digital (DSD) data or audio data from a file accommodating the two types of data, the direct stream digital data being read and written by a direct stream digital (DSD) method in increments of a data volume higher than one sample of data according to the direct stream digital method, the audio data being encoded by an encoding method different from the direct stream digital method, the program causing the computer to carry out a process including the steps of: firstly reproducing the direct stream digital data from the file if there is provided a controllable device capable of reproducing the direct stream digital data; and secondly reproducing the audio data from the file if there is no controllable device capable of reproducing the direct stream digital data.

Where the information processing apparatus, information processing method, and program according to the invention are in use, a file is generated in such a manner as to hold DSD data read and written in increments of a data volume higher than one sample of data according to the DSD method. The file is further arranged to have a storage area for accommodating audio data encoded by an encoding method different from the DSD method. The audio data is generated in a manner encoded by the encoding method different from the DSD method in accordance with the DSD data. The generated audio data is then stored into the storage area of the file.

Also through the use of the information processing apparatus, information processing method, and program according to the invention, the DSD data is reproduced from the file if there is provided a controllable device capable of reproducing the DSD data; and the audio data is reproduced from the file if there is no controllable device capable of reproducing the DSD data.

According to the invention, as outlined above, DSD data is handled more efficiently than before. Even if the personal computer is not equipped with a DSD device, the inventive scheme allows the user of the PC to check out what kind of music is constituted by the DSD data stored in the DSD file.

### BRIEF DESCRIPTION OF THE DRAWINGS

Further objects and advantages of this invention will become apparent upon a reading of the following description and appended drawings in which:
FIG. 1 is a schematic view showing how PCM data and DSD data are sampled;
FIG. 2 is a schematic view showing a typical configuration of a recording and reproducing system to which this invention is applied;
FIG. 3 is a schematic view showing a typical format of a DSD file;
FIG. 4 is a schematic view showing another format of the DSD file;
FIG. 5 is a schematic view showing a typical format in which DSD data placed in the file of FIG. 3 is handled;
FIG. 6 is a block diagram showing a typical structure of a personal computer as part of the configuration in FIG. 2;
FIG. 7 is a block diagram showing a typical functional structure of the personal computer;
FIGS. 8A and 8B are schematic views showing increments in which DSD data and PCM data are transmitted and received;
FIG. 9 is a block diagram showing a typical structure of a DSD file generator as part of the structure in FIG. 7;
FIG. 10 is a block diagram showing a typical structure of a PCM data generator as part of the structure in FIG. 7;
FIG. 11 is a flowchart of steps constituting a recording process performed by the personal computer;
FIG. 12 is a flowchart of steps constituting a reproducing process performed by the personal computer; and
FIG. 13 is a flowchart of steps constituting another reproducing process carried out by the personal computer.

### DETAILED DESCRIPTION OF THE PREFERRED EMBODIMENTS

What is described below as the preferred embodiments of this invention corresponds to the appended claims as follows: the description of the preferred embodiments basically provides specific examples supporting what is claimed. If any example of the invention described below as a preferred embodiment does not have an exactly corresponding claim, this does not means that the example in question has no relevance to the claims. Conversely, if any example of the invention described hereunder has a specifically corresponding claim, this does not mean that the example in question is limited to that claim or has no relevance to other claims.

Furthermore, the description below of the preferred embodiments does not claim to include all examples corresponding to the whole claims. In other words, the description hereunder does not limit or deny any inventive entities which are not covered by the appended claims of this invention but which may be added or brought about by this applicant in the future by divisional application or by amendment.

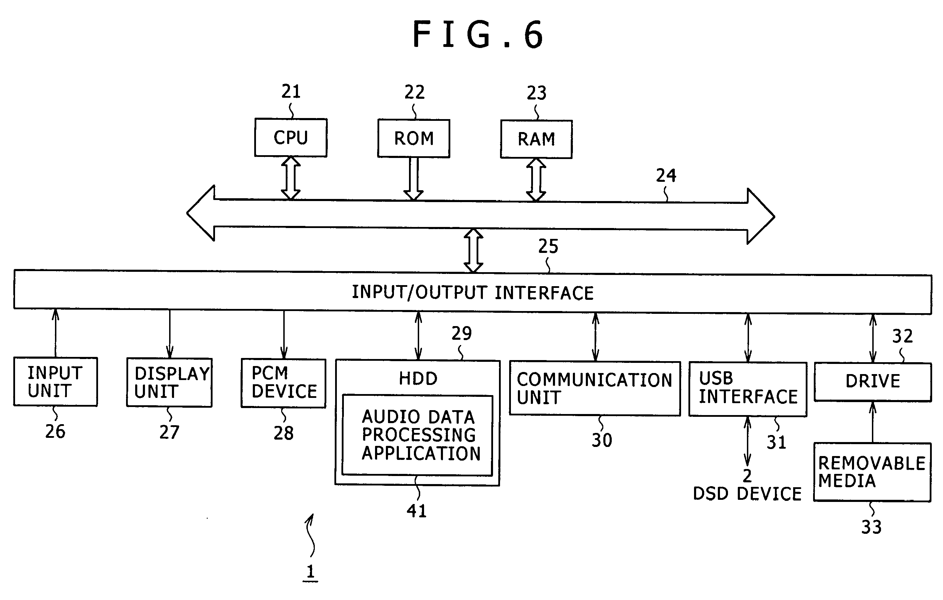

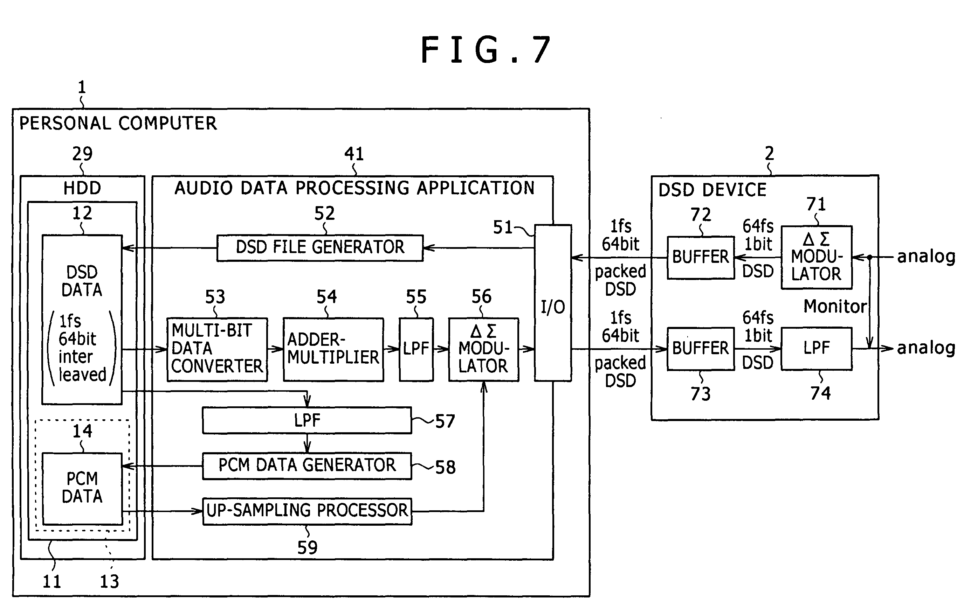

One embodiment of the present invention is an information processing apparatus for storing externally captured DSD data into a file (e.g., DSD file 11 in FIG. 4) for management purposes, the information processing apparatus including: a file generating mechanism (e.g., DSD file generator 52 in FIG. 7) generating the file in such a manner as to hold the DSD data read and written in increments of a data volume (e.g., 4,096 bytes in FIG. 5) higher than one sample of data (e.g., 1 bit) according to a DSD method, the file being further arranged to have a storage area (e.g., PCM data chunk 13 in FIG. 4) for accommodating audio data encoded by an encoding method different from the DSD method; and an audio data generating mechanism (e.g., PCM data generator 58 in FIG. 7) generating the audio data encoded by the encoding method different from the DSD method in accordance with the DSD data, the audio data generating mechanism further storing the generated audio data into the storage area of the file generated by the file generating mechanism.

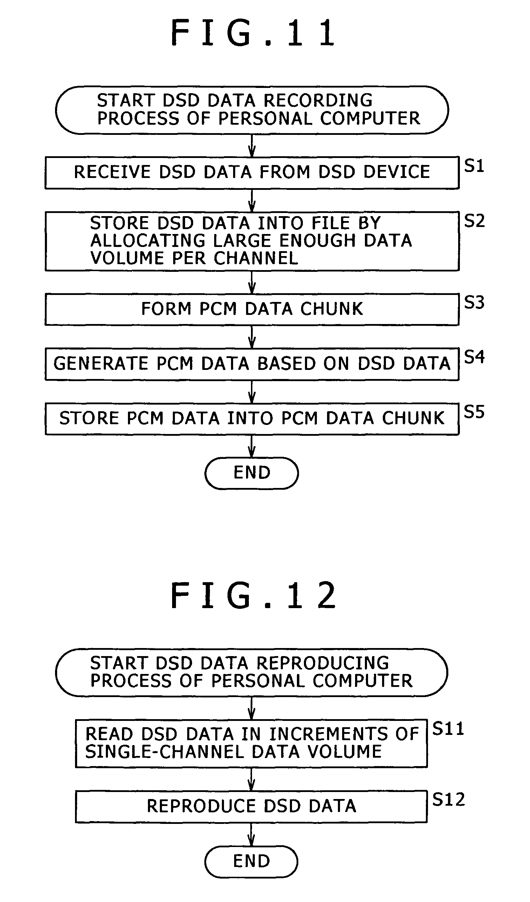

Another embodiment of the present invention is an information processing method for storing externally captured DSD data into a file (e.g., DSD file 11 in FIG. 4) for management purposes, the information processing method including the steps of: generating (e.g., in step S2 of FIG. 11) the file in such a manner as to hold the DSD data read and written in increments of a data volume (e.g., 4,096 bytes in FIG. 5) higher than one sample of data (e.g., 1 bit) according to a DSD method, the file being further arranged to have a storage area (e.g., PCM data chunk 13 in FIG. 4) for accommodating audio data encoded by an encoding method different from the DSD method; and generating (e.g., in step S4 of FIG. 11) the audio data encoded by the encoding method different from the DSD method in accordance with the DSD data, the audio data generating step further storing the generated audio data into the storage area of the file generated in the file generating step.

A further embodiment of the present invention is a program for causing a computer to execute a process including the same steps as those of the inventive information processing method outlined above.

An even further embodiment of the present invention is an information processing apparatus for reproducing either DSD data or audio data from a file (e.g., DSD file 11 in FIG. 4) accommodating the two types of data, the DSD data being read and written by a DSD method in increments of a data volume (e.g., 4,096 bytes in FIG. 5) higher than one sample of data (e.g., 1 bit) according to the DSD method, the audio data being encoded by an encoding method different from the DSD method, the information processing apparatus including: a first reproducing mechanism (e.g., reproduction mechanism made up of the components ranging from a multi-bit data converter 53 to a ΔΣ modulator 56 in FIG. 7) reproducing the DSD data from the file if there is provided a controllable device (e.g., DSD device 2 in FIG. 2) capable of reproducing the direct stream digital data; and a second reproducing mechanism (e.g., PCM device 28 in FIG. 6) reproducing the audio data from the file if there is no controllable device capable of reproducing the direct stream digital data.

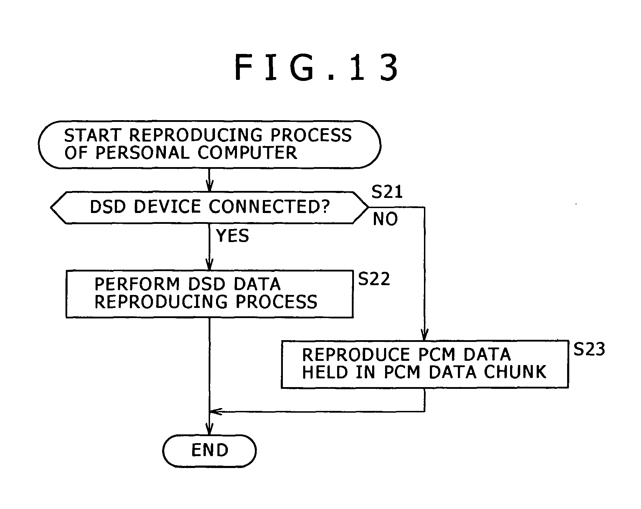

A still further embodiment of the present invention is an information processing method for reproducing either DSD data or audio data from a file (e.g., DSD file 11 in FIG. 4) accommodating the two types of data, the DSD data being read and written by a DSD method in increments of a data volume (e.g., 4,096 bytes in FIG. 5) higher than one sample of data (e.g., 1 bit) according to the DSD method, the audio data being encoded by an encoding method different from DSD method, the information processing method including the steps of: firstly reproducing (e.g., in step S22 of FIG. 13) the DSD data from the file if there is provided a controllable device (e.g., DSD device 2 in FIG. 2) capable of reproducing the DSD data; and secondly reproducing (e.g., in step S23 of FIG. 13) the audio data from the file if there is no controllable device capable of reproducing the DSD data.

A yet further embodiment of the present invention is a program for causing a computer to execute a process including the same steps as those of the inventive information processing method outlined above.

Preferred embodiments of the present invention will now be described with reference to the accompanying drawings. FIG. 2 is a schematic view showing a typical configuration of a recording and reproducing system to which this invention is applied. The recording and reproducing system in FIG. 2 is constituted by a personal computer 1 and a DSD device 2 interconnected illustratively through a USB (Universal Serial Bus) cable 3.

The personal computer 1 receives DSD data (i.e., audio data encoded by the direct stream digital (DSD) method) from the DSD device 2 through the USB cable 3. The received DSD data is placed into a DSD file for management purposes. For example, when the user selects a DSD file, the personal computer 1 reads DSD data from the selected DSD file for reproduction and/or editing purposes.

The DSD device 2, an audio device capable of processing DSD data, is driven by control signals sent over the USB cable 3 from the personal computer 1. Illustratively, the DSD device 2 generates DSD data from an externally supplied analog audio signal and outputs the generated DSD data to the personal computer 1.

FIG. 3 is a schematic view showing a typical format of a DSD file which is generated and managed by the personal computer 1. As indicated in FIG. 3, a DSD file 11 accommodates DSD data 12 supplied from the DSD device 2. The DSD file 11 also has a PCM data chunk 13 formed therein as the area for holding the PCM data (i.e., audio data encoded by the pulse code modulation (PCM) method) generated from the DSD data 12. The PCM data chunk 13 holds the PCM data 14 generated by the personal computer 1, as shown in FIG. 4.

When supplied with the DSD data 12 from the DSD device 2, the personal computer 1 places the received DSD data 12 into one DSD file 11 and forms simultaneously the PCM data chunk 13 in that DSD file 11 (FIG. 3). The personal computer 1 also generates the PCM data 14 from the DSD data 12 and stores the generated PCM data 14 into the PCM data chunk 13 (FIG. 4). As a result, a single DSD file 11 holds two types of audio data: DSD data 12 according to the DSD method, and PCM data 14 based on the PCM method.

The PCM data 14 serves as the audio data to be reproduced if the DSD file 11 is selected by the user for reproduction and if the user's personal computer is not currently equipped with a device (e.g., DSD device 2 in FIG. 1) capable of reproducing the DSD data 12.

That is, if there is provided a device capable of reproducing the DSD data 12, the DSD data 12 is reproduced from the DSD file 11 selected by the user; if there is no device capable of DSD data reproduction, then the personal computer 1 reproduces the PCM data 14 from the selected file. An audio signal obtained by reproducing the PCM data 14 is output illustratively through speakers of the personal computer 1.

It might happen that the user of the personal computer 1 in FIG. 2 gives the DSD file 11 to a second user whose personal computer is not equipped with a device capable of reproducing the DSD data 12. In that case, as long as the second user's personal computer is furnished with a PCM device capable of processing the PCM data 14, the second user can check out what kind of tune is constituted by the DSD data 12 held in the DSD file 11. The PCM device is built in most personal computers.

Returning to the explanation of FIG. 3, the DSD data 12 is written to and read from the DSD file 11 in increments of a relatively large data volume. FIG. 5 schematically shows a typical format in which the DSD data 12 is handled.

As depicted in FIG. 5, the DSD data 12 is arranged alternately on an L (left) and an R (right) channel in increments of 4,096 bytes (4,096 × 8 bits). Illustratively, the 4,096 bytes of data per channel constitute one increment for read and write operations. The volume of 4,096 bytes is sufficiently high compared with the single-sample data volume of DSD data (e.g., 1 bit).

The sufficiently high data volume means that the personal computer 1 can handle large quantities of data efficiently in read and write operations. That efficiency is in sharp contrast to the case where data such as PCM data is written and read in increments of 16 bits per sample.

Where the amount of data is the same, the higher the data volume in increments of which the data is read and written, the smaller the number of times the data needs to be read and written. The personal computer 1 can thus record and reproduce the DSD data 12 in an appreciably smaller number of write and read operations than before. During reproduction of the DSD data 12, the personal computer 1 can read out the data in a manner keeping up with the playback.

The data volume in increments of which to read or write data is not limited to 4,096 bytes as shown in FIG. 5. Any other data volume may serve the purpose as long as the volume in question is higher than the data volume per sample according to the DSD method.

The steps performed by the personal computer 1 to generate the above-described DSD file 11 and manage the DSD data 12 will be discussed later with reference to the accompanying flowcharts.

FIG. 6 is a block diagram showing a typical structure of the personal computer 1 included in FIG. 2. A CPU (Central Processing Unit) 21 performs various processes in keeping with programs held in a ROM (Read Only Memory) 22 or with programs loaded into a RAM (Random Access Memory) 23 from a HDD (Hard Disk Drive) 29. The RAM 23 also accommodates data that may be needed by the CPU 21 in carrying out its diverse processes.

The CPU 21, ROM 22, and RAM 23 are interconnected via a bus 24. An input/output interface 25 is also connected to the bus 24.

The input/output interface 25 is connected to an input unit 26, a display unit 27, a PCM device 28, the HDD 29, a communication unit 30, and a USB interface 31. The input unit 26 is made up of a keyboard and a mouse. The display unit 27 is composed of an LCD (Liquid Crystal Display) or the like.

Under control of the CPU 21, the PCM device 28 reproduces PCM data from the DSD file having the format shown in FIG. 4. An audio signal obtained from the reproduction is output through speakers, not shown.

The HDD 29 stores on its internal hard disks various kinds of data including DSD files. In the example of FIG. 6, the HDD 29 also retains an audio data processing application 41. The application 41, when carried out by the CPU 21, implements diverse functions for processing audio data such as DSD data and PCM data.

The communication unit 30 conducts communications over a network. The USB interface 31 communicates with the DSD device 2 through the USB cable 3. The DSD device 2 sends the DSD data it has generated to the USB interface 31 as discussed above.

A drive 32 is connected as needed to the input/output interface 25. Removable media 33 such as a magnetic disk, an optical disk, a magneto-optical disk, or a semiconductor memory may be loaded into the drive 32. Computer programs retrieved from the removable medium loaded in the drive 32 are installed as needed onto the HDD 29.

FIG. 7 is a block diagram showing a typical functional structure of the personal computer 1. The functional blocks of the personal computer 1 shown in FIG. 7 are implemented by the CPU 21 of FIG. 6 executing the audio data processing application 41. FIG. 7 also shows part of the functional structure of the DSD device 2.

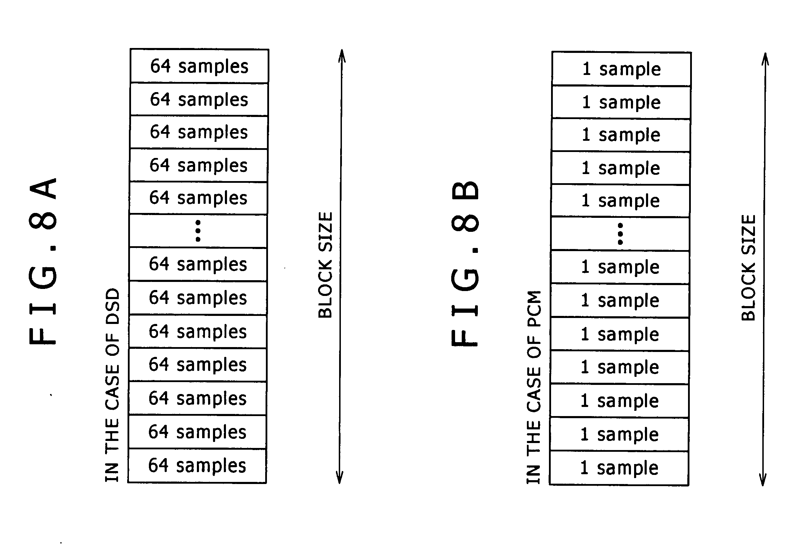

An I/O (Input/Output) 51 of the audio data processing application 41 is an audio driver that controls the DSD device 2. The audio driver receives DSD data from the DSD device 2 and forwards the received DSD data to a DSD file generator 52. For example, as shown in FIG. 8A, the DSD device 2 supplies the I/O 51 with DSD data in increments of a data block constituted by a predetermined number of sub-blocks of 64 samples each (i.e., 64 one-bit data samples occurring during the time period of 64 fs).

FIG. 8B is a schematic view showing a typical data block in increments of which PCM data is exchanged between the personal computer 1 and the DSD device 2 if the latter can handle PCM data as well. As shown in FIG. 8B, each block of PCM data is constituted by a predetermined number of sub-blocks of 1 sample (16 bits) each, as opposed to the 64 samples making up one sub-block of DSD data. It follows that basically the same device structure can be used to handle both DSD data and PCM data, provided each sub-block is allowed to vary in size between 1 sample and 64 samples.

The I/O 51 further forwards the DSD data sent from the ΔΣ modulator 56 to the DSD device 2. Illustratively, upon reproduction of DSD data (contained in a DSD file) retrieved from the HDD 29, the DSD data is sent from the △Σ modulator 56.

The DSD file generator 52 generates a DSD file 11 into which to place the DSD data 12 sent from the I/O 51. The DSD file 11 thus generated is written to the HDD 29.

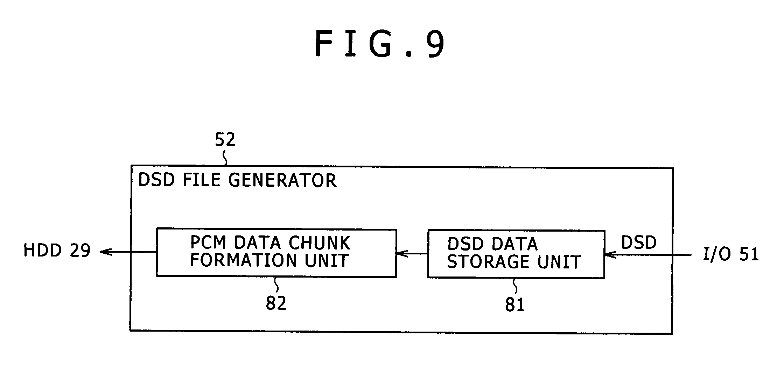

FIG. 9 is a block diagram showing a typical structure of the DSD file generator 52. The DSD file generator 52 is made up of a DSD data storage unit 81 and a PCM data chunk formation unit 82.

The DSD data storage unit 81 places the DSD data 12 into the DSD file 11 coming from the I/O 51, and forwards the DSD file 11 together with the DSD data 12 to the PCM data chunk formation unit 82. The DSD data 12 placed into the DSD file 11 by the DSD data storage unit 81 is the type of data that is written and read in increments of a high data volume as explained above with reference to FIG. 5.

The PCM data chunk formation unit 82 forms a PCM data chunk 13 in the DSD file 11 in which the DSD data 12 has been stored following generation by the DSD data storage unit 81. The DSD file 11 with the PCM data chunk 13 formed therein is written to the HDD 29.

Returning to the explanation of FIG. 7, a multi-bit data converter 53 is provided to convert the DSD data 12 from its one-bit per-sample data format into a multi-bit data format of 1s and -1s. The converting process, carried out preparatory to the additions and multiplications to be made on the DSD data 12 retrieved from the HDD 29, is intended to prevent overflows during such data processing. The multi-bit data obtained by the multi-bit data converter 53 is output to an adder-multiplier 54.

The adder-multiplier 54 performs cross-fades using additions and multiplications or volume adjustments using multiplications on the data fed from the multi-bit data converter 53. The data obtained from the processing (i.e., multi-bit data) is output to a Low Pass Filter (LPF) 55.

The LPF 55 removes high-frequency components from the data and forwards the resulting data to the ΔΣ modulator 56. The reason the high-frequency components are removed from the data is that quantization noises accumulated from the repeated operations on the DSD data 12 subject to the noise shaping effect of△Σ modulation could lead to hardware destruction (e.g., of tweeters) if the DSD data 12 were reproduced unchecked.

The ΔΣ modulator 56 acquires 64-fs/1-bit DSD data by performing ΔΣ modulation on the data fed from the LPF 55, and outputs the acquired DSD data to the I/O 51. A low-pass filter (LPF) 74 in the DSD device 2 removes from the data the quantization noises which have been separated from the original signal by the noise-shaping effect of ΔΣ modulation and which are formed in the high-frequency component of the data.

The ΔΣ modulator 56 converts into 64-fs/1-bit DSD data the 64-fs/16-bit PCM data that is sent from an up-sampling processor 59 illustratively upon reproduction of the PCM data 14 in the DSD file 11. The DSD data thus obtained is output to the I/O 51.

The LPF 57 thins out the DSD data 12 held in the DSD file 11 so as to generate illustratively 32-bit (1-fs/32-bit) PCM data. Following the thinning-out process of the LPF 57, the 32-bit PCM data is output to a PCM data generator 58. The LPF 57 is constituted illustratively by an LPF from Intel Performance Primitive (IPP).

The PCM data generator 58 generates 16-bit or 24-bit PCM data 14 based on the PCM data coming from the LPF 57. The generated PCM data is stored into the PCM data chunk 13 of the DSD file 11.

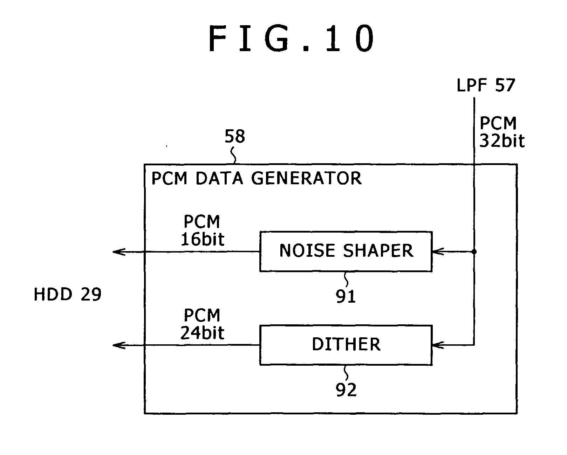

FIG. 10 is a block diagram showing a typical structure of the PCM data generator 58. The PCM data generator 58 is made up of a noise shaper 91 and a dither 92.

The noise shaper 91 generates 16-bit PCM data from the 32-bit PCM data supplied from the LPF 57. This converting process involves illustratively the use of SBM (Super Bit Mapping) whereby only the number of quantized bits is reduced while the sound quality of the original PCM data is maintained.

The dither 92 generates 24-bit PCM data from the 32-bit PCM data sent from the LPF 57. For example, either the PCM data generated by the noise shaper 91 or the PCM data generated by the dither 92 is stored as the PCM data 14 into the PCM data chunk 13 of the DSD file 11. Obviously, both the PCM data generated by the noise shaper 91 and the PCM data generated by the dither 92 may be stored as the PCM data 14 into the PCM data chunk 13 if that is feasible.

Returning to the explanation of FIG. 7, the up-sampling processor 59 samples 1-fs/16-bit or 1-fs/24-bit PCM data at 64 times its sampling frequency when the PCM data 14 in the DSD file 11 is to be reproduced. The 64-fs PCM data acquired through the up-sampling is output to the ΔΣ modulator 56.

A ΔΣ modulator 71 of the DSD device 2 carries out ΔΣ modulation on the analog audio signal coming from an external device, not shown, to obtain 64-fs/1-bit DSD data that is sent to a buffer 72. The DSD device 2 has a direct monitoring capability enabling the output side also to receive the analog audio signal entered into the DSD device 2 (i.e., ΔΣ modulator 71). The output side is thus allowed to monitor the input audio signal with no time lag.

The buffer 72 buffers the 64-fs/1-bit DSD data sent from the ΔΣ modulator 71. The buffered DSD data is output to the I/O 51 of the personal computer in increments of the data block shown in FIG. 8A.

A buffer 73 is provided to buffer the DSD data coming from the I/O 51 of the personal computer 1. The buffered 64-fs/1-bit DSD data per sample is output to the LPF 74.

The LPF 74 removes the quantization noises accumulated in the high-frequency band of the 64-fs/1-bit DSD data sent from the buffer 73, and turns the data into analog format. The analog audio signal thus generated is output to an external device such as speakers.

How the personal computer 1 of the above-described structure works will now be described. Described below with reference to the flowchart of FIG. 11 is a DSD data recording process of the personal computer 1.

This recording process is carried out illustratively when, with the DSD device 2 connected to the personal computer 1, the audio data processing application 41 is executed and an analog audio signal is input to the DSD device 2. Input of the analog audio signal to the DSD device 2 prompts the ΔΣ modulator 71 to carry out ΔΣ modulation on the input signal thus generating the DSD data 12. The generated DSD data 12 is output to the personal computer 1.

In step S1 of FIG. 11, the I/O 51 receives the DSD data 12 from the DSD device 2 in increments of the data block shown in FIG. 8A, and outputs the received data to the DSD file generator 52.

In step S2, the DSD data storage unit 81 (FIG. 9) of the DSD file generator 52 stores the DSD data 12 from the I/O 51 into the DSD file 11 by allocating a large enough per-channel data volume in increments of which to read the DSD data 12. The DSD file 11 containing the DSD data 12 from the DSD data storage unit 81 is output to the PCM data chunk formation unit 82.

In step S3, the PCM data chunk formation unit 82 forms a PCM data chunk 13 in the DSD file 11 generated by the DSD data storage unit 81. The DSD file 11 together with its PCM data chunk 13 is written to the HDD 29.

In step S4, the LPF 57 generates illustratively 32-bit PCM data by thinning out the DSD data 12 placed in the DSD file 11, and outputs the generated PCM data to the PCM data generator 58. Also in step S4, the noise shaper 91 or dither 92 of the PCM data generator 58 generates PCM data in such a manner that its quantization bit count is made smaller than that of the PCM data which was sent from the LPF 57 and from which the PCM data with the smaller quantization bit count is generated. In step S5, the generated PCM data is regarded as the PCM data 14 and is stored into the PCM data chunk 13 of the DSD file 11.

Carrying out the steps above generates a DSD file that accommodates DSD data written and read in increments of a relatively high data volume. The generated DSD file is also arranged in a manner enabling the user to ascertain the content of the DSD data even if the user's personal computer is not equipped with a DSD device.

Described below with reference to the flowchart of FIG. 12 is a process performed by the personal computer 1 to reproduce the DSD data 12. In step S11, the multi-bit data converter 53 reads the DSD data 12 from the HDD 29 illustratively in increments of 4,096 bytes per channel. In step S12, the retrieved DSD data is reproduced.

More specifically, in step S12, the multi-bit data converter 53 converts the 64-fs/1-bit DSD data 12 into multi-bit data. The adder-multiplier 54 performs cross fades and volume adjustments on the multi-bit data thus obtained. The processed data output by the adder-multiplier 54 has its high-frequency components removed by the LPF 55. Passed the LPF 55, the data is subjected to ΔΣ modulation by the ΔΣ modulator 56. The DSD data resulting from the ΔΣ modulation is sent through the I/O 51 to the DSD device 2 which then outputs the data.

Described above is the manner in which DSD data is read out in increments of a high data volume in an efficient read operation carried out by the personal computer 1. This scheme forestalls sound interruption by allowing the personal computer 1 to read DSD data in a manner keeping up with the reproduction.

Described below with reference to the flowchart of FIG. 13 is a process performed by the personal computer 1 to reproduce the DSD file 11 generated by the process of Fig 1.

Illustratively, the user selects the DSD file 11 and designates its reproduction. In that case, the CPU 21 (FIG. 6) goes to step S21 and checks to determine whether a controllable DSD device 2 is connected to the personal computer 1 as a controllable device.

On the other hand, if in step S21 the CPU 21 determines that the DSD device 2 is connected, then step S22 is reached. In step S22, the CPU 21 proceeds to reproduce the DSD data 12 held in the DSD file 11 selected by the user. That is, the same process as that discussed above with reference to FIG. 12 is carried output to reproduce the DSD data 12.

If in step S21 the CPU 21 determines that the DSD device 2 is not connected, then step S23 is reached. In step S23, the CPU 21 proceeds to reproduce the PCM data 14 placed in the user-selected DSD file 11. For example, the PCM data 14 held in the DSD file 11 is sent from there to the PCM device 28 through the input/output interface 25 (FIG. 6). In turn, the PCM device 28 reproduces the received PCM data 14.

In that manner, even if the DSD device 2 is not connected, the user of the personal computer 1 is able to verify the content of the DSD data 12 placed in the DSD file 11.

In the foregoing description, it was assumed that the audio data placed in the DSD file 11 together with the DSD data 12 is the PCM data 14. However, this is not limitative of the invention. Alternatively, the DSD file 11 may accommodate audio data in any other compressed data format compatible with more personal computers in reproduction than the DSD data 12, including ATRAC3 (Adaptive Transform Acoustic Coding) data, MP3 (MPEG Audio Layer-3) data, and WMA (Windows (registered trademark) Media Audio) data.

The series of steps or processes described above may be executed either by hardware or by software. For the software-based processing to take place, the programs constituting the software may be either incorporated beforehand in dedicated hardware of a computer or installed upon use over a network or from a suitable storage medium into a general-purpose personal computer or like equipment capable of executing diverse functions based on the installed programs.

As shown in FIG. 6, the storage medium is offered to the user apart from the computer or like equipment not only as removable media 33 constituted by magnetic disks (including flexible disks), optical disks (including CD-ROM (Compact Disk-Read Only Memory) and DVD (Digital Versatile Disk)), magneto-optical disks (including MD (Mini-Disk; registered trademark)), or a semiconductor memory, each of the media carrying the necessary programs; but also in the form of the ROM 22 or the HDD 29 containing hard disks, both accommodating the programs and incorporated beforehand in the computer.

In this specification, the steps describing the programs to be executed represent not only the processes that are to be carried out chronologically in the depicted sequence but also processes that may be performed parallelly or individually.

In this specification, the term "system" refers to an entire configuration made up of a plurality of component devices.

As many apparently different embodiments of this invention may be made without departing from the spirit and scope thereof, it is to be understood that the invention is not limited to the specific embodiments thereof except as defined in the appended claims.

## Claims

1. An information processing apparatus for storing externally captured direct stream digital data into a file for management purposes, said information processing apparatus comprising:
file generating means for generating said file in such a manner as to hold said direct stream digital data read and written in increments of a data volume higher than one sample of data according to a direct stream digital method, said file being further arranged to have a storage area for accommodating audio data encoded by an encoding method different from said direct stream digital method; and
audio data generating means for generating said audio data encoded by said encoding method different from said direct stream digital method in accordance with said direct stream digital data, said audio data generating means further storing the generated audio data into said storage area of said file generated by said file generating means.

2. The information processing apparatus according to claim 1, wherein said audio data is pulse code modulation data.

3. An information processing method for storing externally captured direct stream digital data into a file for management purposes, said information processing method comprising the steps of:
generating said file in such a manner as to hold said direct stream digital data read and written in increments of a data volume higher than one sample of data according to a direct stream digital method, said file being further arranged to have a storage area for accommodating audio data encoded by an encoding method different from said direct stream digital method; and
generating said audio data encoded by said encoding method different from said direct stream digital method in accordance with said direct stream digital data, said audio data generating step further storing the generated audio data into said storage area of said file generated in said file generating step.

4. A program for causing a computer to store externally captured direct stream digital data into a file for management purposes, said program causing said computer to carry out a process comprising the steps of:
generating said file in such a manner as to hold said direct stream digital data read and written in increments of a data volume higher than one sample of data according to a direct stream digital method, said file being further arranged to have a storage area for accommodating audio data encoded by an encoding method different from said direct stream digital method; and
generating said audio data encoded by said encoding method different from said direct stream digital method in accordance with said direct stream digital data, said audio data generating step further storing the generated audio data into said storage area of said file generated in said file generating step.

5. An information processing apparatus for reproducing either direct stream digital data or audio data from a file accommodating the two types of data, said direct stream digital data being read and written by a direct stream digital method in increments of a data volume higher than one sample of data according to said direct stream digital method, said audio data being encoded by an encoding method different from said direct stream digital method, said information processing apparatus comprising:
first reproducing means for reproducing said direct stream digital data from said file if there is provided a controllable device capable of reproducing said direct stream digital data; and
second reproducing means for reproducing said audio data from said file if there is no controllable device capable of reproducing said direct stream digital data.

6. The information processing apparatus according to claim 5, wherein said audio data is pulse code modulation data.

7. An information processing method for reproducing either direct stream digital data or audio data from a file accommodating the two types of data, said direct stream digital data being read and written by a direct stream digital method in increments of a data volume higher than one sample of data according to said direct stream digital method, said audio data being encoded by an encoding method different from said direct stream digital method, said information processing method comprising the steps of:
firstly reproducing said direct stream digital data from said file if there is provided a controllable device capable of reproducing said direct stream digital data; and
secondly reproducing said audio data from said file if there is no controllable device capable of reproducing said direct stream digital data.

8. A program for causing a computer to reproduce either direct stream digital data or audio data from a file accommodating the two types of data, said direct stream digital data being read and written by a direct stream digital method in increments of a data volume higher than one sample of data according to said direct stream digital method, said audio data being encoded by an encoding method different from said direct stream digital method, said program causing said computer to carry out a process comprising the steps of:
firstly reproducing said direct stream digital data from said file if there is provided a controllable device capable of reproducing said direct stream digital data; and
secondly reproducing said audio data from said file if there is no controllable device capable of reproducing said direct stream digital data.
